# EUROPÄISCHE PATENTSCHRIFT

(11) **EP 0 563 676 B1**
(45) Veröffentlichungstag und Bekanntmachung des Hinweises auf die Patenterteilung: **17.05.2000**
(21) Anmeldenummer: 93104255.0
(22) Anmeldetag: 16.03.1993
(51) Int. Cl.: G01R 35/00, H04M 3/30, G01R 31/28

(54) **Verfahren zum Abgleichen der Sende- und Messschaltung einer Prüfeinrichtung**
Calibrating method for the transmitting and measuring circuit of a test appliance
Procédé de calibrage d'un circuit émetteur et de mesure d'un dispositif de test

(30) Priorität: 31.03.1992 DE 4210620
(43) Veröffentlichungstag der Anmeldung: 06.10.1993
(73) Patentinhaber: SIEMENS AKTIENGESELLSCHAFT, 80333 München (DE)
(72) Erfinder: Gnan, Günther, Dipl.-Ing., W-8038 Gröbenzell (DE); Kaiser, Wolfgang, Dipl.-Ing. (FH), W-8228 Freilassing (DE); Preiss, Frank, Dipl.-Phys., W-8080 Fürstenfeldbruck (DE); Schmutzler, Werner, W-8080 Fürstenfeldbruck (DE)

(56) Entgegenhaltungen:
- US-A- 4 404 636
- IEEE TRANSACTIONS ON COMMUNICATIONS, Bd.COM-29, Nr.10, Oktober 1981, NEW YORK US Seiten 1434 - 1441 T. A. HANRAHAN ET AL. 'Subscriber Line Testing for Digital Switching Offices'
- PATENT ABSTRACTS OF JAPAN Bd. 14, Nr. 498 (P-1124) 30 Oktober 1990 & JP-A-02 203 213 (HITACHI LTD) 13 August 1990
- PATENT ABSTRACTS OF JAPAN vol. 12, no. 133 (P-693) 22. April 1988 & JP-A-62 254 076 (MITSUBISHI ELECTRIC CORP.) 5. November 1987

## Beschreibung

Bei der Entstörung von Teilnehmeranschlüssen werden in Vermittlungsstellen Prüfeinrichtungen zur Lokalisierung der Fehlerstellen eingesetzt. Solche Prüfeinrichtungen beinhalten Sende- und Meßschaltungen, die Prüfsignale von der Digitalseite einer Teilnehmeranschlußschaltung zur Teilnehmerleitungsseite oder von der Teilnehmerleitungsseite der Teilnehmeranschlußschaltung zur Vermittlungsstellenseite senden und von dort empfangen können. Der Abgleich einer solchen Sende- und Meßschaltung mit Potentiometern und Lötbrücken im Pruffeld ist aufwendig und über längere Zeit nicht konstant genug.

Das Dokument IEEE TRANSACTIONS ON COMMUNICATIOS, Bd. COM-29 Nr.10, Oktober 1981, New York US, Seiten 1434-1441, T.A. HANRAHAN et Al. 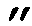 Subscriber Line Testing for Digital Switching Offices offenbart eine Prüfeinrichtung, bei der angegeben ist, daß sie sich selbst abgleicht. Die Art und Weise wie dieser Abgleich vor sich geht, ist in D1 jedoch nicht angegeben.

In dem Dokument PATENT ABSTRACTS OF JAPAN vol.14, no. 498 (P-1124), 30. Oktober 1990 & JP-A-22 003 213 (HITACHI LTD) 13. August 1990 ist ein Verfahren zum Abgleich einer Meßschaltung angegeben.

Der Erfindung liegt das Problem zugrunde, ein Verfahren zum Abgleichen einer Sende- und Meßschaltung sowie eine Prüfeinrichtung zur Durchführung des Verfahrens anzugeben.

Dieses Problem wird durch ein Verfahren gemäß Anspruch 1 bzw. eine Prüfeinrichtung gemaß Anspruch 2 gelöst.

Durch die erfindungsgemäßen Verfahrensschritte wird ein selbständiger Abgleich der Prüfeinrichtung während des Betriebs ermöglicht.

Durch die erfindungsgemäße Prüfeinrichtung gemäß Anspruch 2 wird es ermöglicht, daß die für den selbständigen Abgleich notwendigen Verfahrensschritte softwaremäßig realisiert werden können.

Im folgenden wird eine Ausführungsform der Erfindung anhand der Zeichnung näher erläutert.

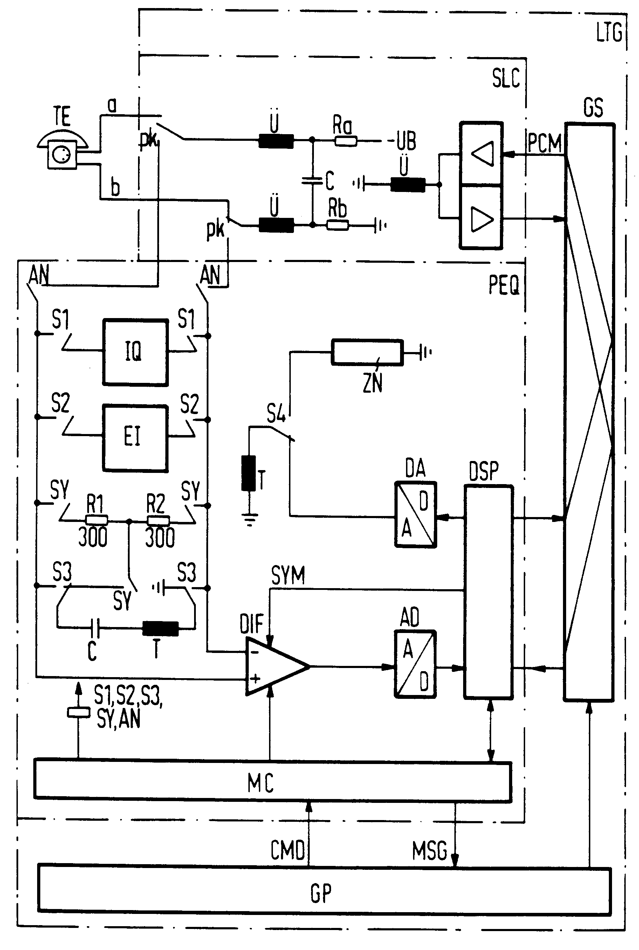

Figur 1 zeigt die Einbettung einer Prüfeinrichtung PEQ zur Prüfung einer Teilnehmerschaltung SLC innerhalb einer Anschlußgruppe LTG eines Vermittlungssystems.
Die Teilnehmerschaltung SLC umfaßt vereinfacht dargestellt Speisewiderstände Ra und Rb, über die eine Gleichspannung UB eingespeist wird, einen Übertrager Ü, der die Sprachwechselspannung von der Teilnehmeranschlußleitung a/b zum PCM-Interfache IN und umgekehrt überträgt und einen Kondensator C, der den Wechselstromkreis schließt. Das PCM-Interface bildet dabei den Übergang von der analogen Übertragungsseite zur digitalen Übertragungsseite. Auf der digitalen Übertragungsseite ist die Sprechwechselspannung in ihre gehenden und kommenden Anteile getrennt und nach dem PCM-Verfahren kodiert. Zu Prüfzwecken ist die digitale Seite der Teilnehmerschaltung über eine Koppeleinrichtung GS mit der Prüfeinrichtung verbindbar. Die analoge Seite der Teilnehmerschaltung ist zu Prüfzwecken durch Prüfkopplerkontakte Pk mit der Prüfeinrichtung verbindbar.

Die Prüfeinrichtung umfaßt verschiedene Relais, eine Konstantstromsenke IQ, einen Eichgeneraor EI, eine symmetrische Toneinspeiseschaltung, eine Leitungsnachbildung ZN, einen Differenzverstärker DIF, einen Signalprozessor DSP mit vorgeschalteten Digital/Analalog-Wandler DA sowie Analog/Digitalwandler AD, und einen Mikrocomputer MC.

Die genannte symmetrische Toneinspeiseschaltung umfaßt Einspeisewiderstände R1 und R2, in deren Mitte hinter einem Kondensator C ein Sendeübertrager T angeschaltet ist. Der zweite Teil des Sendeübertragers T ist mit dem Digital/Analog-Wandler des Signalprozessors verbindbar.

Bei den genannten Relais der Prüfeinrichtung handelt es sich um ein Relais AN zur Anschaltung der Prüfeinrichtung an den Prüfling (Teilnehmerschaltung), ein Relais S1 zur Anschaltung der Konstantstromsenke, ein Relais S2 zur Anschaltung des Eichgenerators EI, ein Relais S3 zur Anschaltung des Sendeübertragers T, ein Relais S4 zur Umschaltung des Sendeübertragers T vom Digital/Analog-Wandler auf die Leitungsnachbildung ZN und ein Relais SY zur Anschaltung der symmetrischen Toneinspeiseschaltung.

Die Leitungsnachbildung ZN dient als Leitungsabschluß bei bestimmten Messungen, z.B. bei der Messung der Gabelübergangsdämpfung.

Der Signalprozessor DSP realisiert sowohl den wesentlichen Teil einer Sendeschaltung zum Senden von Prüfsignalen, als auch den wesentlichen Teil einer Meßschaltung zum Messen von Meßsignalen und kann sowohl an die Analogseite der Teilnehmerschaltung SLC als auch über eine Koppeleinrichtung GS an die digitale Seite der Teilnehmerschaltung SLC angeschaltet werden. Für die Anschaltung an die analoge Seite der Teilnehmerschaltung sind dem Signalprozessor zum Senden ein Digital/Analog-Wandler DA und zum Empfangen ein Analog/Digitalwandler DA vorgeschaltet.

Die analoge Meßschaltung der Prüfeinrichtung wird vom Signalprozessor, dem Analog/Digital-Wandler AD und dem Differenzverstärker DIF gebildet. Der Differenzverstärker koppelt hierbei den Wechselspannungsanteil der Spannung zwischen a- und b- Ader aus und führt ihn über den Analog/Digital-Wandler dem Signalprozessor zur Auswertung zu.

Der Differenzverstärker hat drei Betriebszustände, die vom Mikrocomputer bzw. vom Signalprozessor über ein Steuersignal V eingestellt werden. Einen ersten Betriebzustand mit 0 dB-Verstärkung, einen zweiten Betriebszustand mit 25 dB-Verstärkung und einen dritten Betriebszustand, den sogenannten Unsymmetrie-Abgleichmode. In diesem dritten Betriebszutand wird die Eigenunsymmetrie des Differenzverstärkers abgeglichen, indem er während des Sendens von Prüfsignalen, jedoch vor der eigentlichen Messung intern kurzgeschlossen wird und aufgrund des dann noch vorhandenen Ausgangssignals für die darauffolgende Messung ein Meßkorrekturfaktor berechnet und mit dem Meßergebnis zu dessen Berichtiung multipliziert wird. Damit erübrigt sich ein Abgleich des Differenzverstärkers im Prüffeld. Das interne Kurzschließen des Differenzverstärkers hat dabei keine Rückwirkung auf die an dessen Eingang anliegenden Meßsignale.

Die analoge Sendeschaltung wird vom Signalprozessor, dem Digital/Analog-Wandler DA und dem Sendeübertrager T gebildet. Der Signalprozessor erzeugt ein Signal in digitaler Form, welches mit Hilfe des Digital/ Analog-Wandlers in analoge Schwingungen umgewandelt wird und über den Sendeübertrager auf die Teilnehmeranschlußleitung eingespeist wird.

Die analoge Sendeschaltung kann zur Überwachung der internen Funktionstüchtigkeit der Prüfeinrichtung mit der analogen Meßschaltung in einem Eigenprüfungsmodus zusammengeschaltet werden.

Der Signalprozessor DSP mißt in seinem Empfangsteil den Effektivwert von Wechselspannungen und gibt diesen als Pegelwert in dB an den Mikrocomputer MC weiter.

Die Wechselspannungen können von der Analogseite der Teilnehmerschaltung über den Analog-Digital-Wandler oder von der Digitalseite der Teilnehmerschaltung über die Koppeleinrichtung GS empfangen werden. Bei Bedarf können digitale Bewertungsfilter zugeschaltet werden, die das Meßergebnis entsprechend qualifizieren. Zur Realisierung dieser Bewertungsfilter ist in der Software für den Signalprozessor ein Prozeß implementiert, der Werte einer komplexen Übertragungsfunktion berechnet. Durch Laden von verschiedenen Koeffizienten in die Übertragungsfunktion werden je nach Meßaufgabe unterschiedliche Filtercharakteristiken erzeugt. Die von der Analogseite gemessenen Effektivwerte werden mit einem Meßkorrekturfaktor multipliziert, der die Toleranzen der analogen Bauteile berücksichtigt. Er wird dadurch ermittelt, daß vom Eichgenerator EI ein Eichsignal mit einem definierten Pegelwert gesendet und mit dem empfangenen Pegelwert ins Verhältnis gesetzt wird.

Der Signalprozessor erzeugt in seinem Sendeteil Prüfsignale, deren Frequenz und Pegel einstellbar sind. Sie können analog über den Digital/Analog-Wandler oder digital über den PCM-Bus zum Prüfling gesendet werden. Die zum Digital/Analog-Wandler gesendeten Prüfsignale werden mit einem Sendekorrekturfaktor multipliziert, der die Toleranzen der analogen Bauteile der Sendeschatung berücksichtigt. Der Sendekorrekturfaktor wird dadurch ermittelt, daß zu der bereits geeichten analogen Meßschaltung ein Eichsignal mit einem definierten Pegelwert gesendet und mit dem empfangenen Pegelwert ins Verhältnis gesetzt wird.

Zur Realisierung von Sinusschwingungen ist in der Software für den Signalprozessor ein Prozeß implementiert, der Amplitudenwerte über eine Potenzreihe berechnet. Dies ergibt Momentanwerte eines Sinussignals der vorgegebenen Frequenz. Durch das Abtastverfahren treten bei der Umwandlung in eine analoge Schwingung frequenzabhängige Verzerrungen auf. Deshalb wird in einem weiteren Rechenschritt der Amplitudenwert korrigiert.

Der Mikrocomputer MC erhält von der Prüfsoftware der Gruppensteuerung GP über entsprechende Kommandos CMD Meßaufträge und sendet über entsprechende Meldungen MSG die Meßergebnisse wiederum an die Gruppensteuerung der Anschlußgruppe LTG zurück. Zum Messen stellt der Mikrocomputer die Relais S1, S2, S3, S4, Sy und AN der Prüfeinrichtung PEQ entsprechend ein und aktiviert den Signalprozessor DSP. Dabei wird das zum Messen vom Signalprozessor benötigte Programm vom Mikrocmputer in den Arbeitsspeicher des Signalprozessors geladen. Dadurch wird es ermöglicht, daß das Steuerprogramm für den Mikrocomputer und die Signalprozeß-Programme für den Signalprozessor in einem zentralen EPROM untergebracht werden können. Bei einem Wechsel der Firmware muß daher nur ein Baustein ausgetauscht werden. Zudem verringern sich die Kosten, da der Signalprozessor wegen seiner hohen Taktrate schnelle und daher teure EPROM benötigen würde.

In einem an die zulässige Temperaturänderung des Systems angepaßten Zeitraster startet der Mikrocomputer einen Eichvorgang zum Abgleich der analogen Meßschaltung und der analogen Sendeschaltung.

Der eigentliche Eichvorgang wird durch den Signalprozessor durchgeführt. Zunächst wird der analoge Pegelempfänger geeicht. Hierzu erzeugt der Eichgenerator EI eine Dreieck-Schwingung mit kosntanter Frequenz und Amplitude. Der Spannungswert der Amplitude ist von einer Referenz-Spannungsquelle abgeleitet. Die Dreieck-Schwingung ist deshalb von Vorteil, weil ihr Effektivwert von Abtastfehlern durch das Analog/Digital-Wandlungsprinzip am geringsten beeinflußt wird. Die Meßschaltung empfängt daraufhin das Eichsignal und ermittelt daraus einen Meßkorrekturfaktor, indem sie den erwarteten Pegelwert mit dem tatsächlich empfangenen Pegelwert ins Verhältnis setzt. Durch Berücksichtigung dieses Meßkorrekturfaktors bei der Ermittlung des Meßwertes ist die Meßschaltung abgeglichen und es wird nunmehr die Sende- und Meßschaltung für den nachfolgenden Abgleich der Sendeschaltung zusammengeschaltet. Die Sendeschaltung erzeugt hierzu ein Eichsignal, das von der nun abgeglichenen Meßschaltung empfangen wird. Zur Ermittlung des Sendekorrektorfaktors wird wie vorher der erwartete Meßwert mit dem empfangenen Meßwert, der bereits mit dem Meßkorrekturfaktor multipliziert ist, ins Verhältnis gesetzt. Der Eichvorgang ist damit abgeschlossen.

## Patentansprüche

1. Verfahren zum Abgleichen der Sende- und Meßschaltung einer Prüfeinrichtung, demgemäß
- von einem separaten Eichgenerator (EI) ein erstes Eichsignal erzeugt wird, wobei der Eichgenerator (EI) hierzu über Schaltmittel mit der Meßschaltung verbunden wird,
- aus dem empfangenen ersten Eichsignal in der Meßschaltung ein Meßwert gebildet wird und dieser Meßwert mit dem erwarteten Meßwert zur Erzeugung eines die Meßschaltung abgleichenden Meßkorrekturfaktors ins Verhältnis gesetzt wird,
**dadurch gekennzeichnet, daß**
- sodann die Sende- und Meßschaltung für den nachfolgenden Abgleich der Sendeschaltung zusammengeschaltet werden,
- von der Sendeschaltung ein zweites Eichsignal erzeugt wird, das von der nun abgeglichenen Meßschaltung empfangen wird,
- aus dem empfangenen zweiten Eichsignal in der Meßschaltung ein Meßwert gebildet wird und dieser Meßwert mit dem erwarteten Meßwert zur Erzeugung eines die Sendeschaltung abgleichenden Sendekorrekturfaktors ins Verhältnis gesetzt wird.

2. Prüfeinrichtung zum Prüfen einer Schaltungsanordnung, mit
a)einer Sendeschaltung zum Senden von Prüfsignalen zu der Schaltungsanordnung,
b)einer Meßschaltung zum Empfangen von durch die Prüfsignale bedingten Antwortsignalen von der Schaltungsanordnung,
c)einem Eichgenerator (EI), der ein erstes Eichsignal zum Abgleichen der Meßschaltung erzeugt,
d)erste Schaltmittel, durch die der Eichgenerator und die Meßschaltung während des Abgleichens der Meßschaltung zusammengeschaltet sind, wobei die Meßschaltung aus dem empfangenen ersten Eichsignal einen Meßwert bildet und diesen Meßwert mit dem erwarteten Meßwert zur Erzeugung eines die Meßschaltung abgleichenden Meßkorrekturfaktors ins Verhältnis setzt,
**dadurch gekennzeichnet, daß**
e)die Sende- und Meßschaltung während des Abgleichens der Sendeschaltung durch zweite Schaltmittel zusammengeschaltet sind,
f)die Sendeschaltung zum Abgleichen ihrerselbst ein zweites Eichsignal erzeugt, das von der abgeglichenen Meßschaltung empfangen wird, worauf die Meßschaltung aus dem empfangenen zweiten Eichsignal einen Meßwert bildet und diesen Meßwert mit dem erwarteten Meßwert zur Erzeugung eines die Sendeschaltung abgleichenden Sendekorrekturfaktors ins Verhältnis setzt.

## Claims

1. Method for adjusting the transmission and measuring circuit of a test device, according to which
- a first calibration signal is generated by a separate calibration generator (EI), the calibration generator (EI) being connected for this purpose to the measuring circuit via switching means,
- a measured value is formed from the received, first calibration signal in the measuring circuit, and the ratio of this measured value to the expected measured value is formed in order to generate a measurement correction factor which adjusts the measurement circuit,
characterized in that
- the transmission and measuring circuit are then connected to one another for the subsequent adjustment of the transmission circuit,
- a second calibration signal, which is received by the now adjusted measurement circuit is generated by the transmission circuit,
- a measured value is formed from the received, second calibration signal in the measuring circuit, and the ratio of this measured value to the expected measured value is formed in order to generate a transmission correction factor which adjusts the transmission circuit.

2. Test device for testing a circuit arrangement, having
a) a transmission circuit for transmitting test signals to the circuit arrangement,
b) a measuring circuit for receiving from the circuit arrangement response signals which are conditioned by the test signals,
c) a calibration generator (EI) which generates a first calibration signal for adjusting the measuring circuit,
d) first switching means by means of which the calibration generator and the measuring circuit are connected together during the adjustment of the measuring circuit, the measuring circuit forming a measured value from the received, first calibration signal, and the ratio of this measured value to the expected measured value is formed in order to generate a measurement correction factor which adjusts the measuring circuit, characterized in that
e) the transmission and measuring circuits are connected together using second switching means, during the adjustment of the transmission circuit,
f) for the sake of adjustment, the transmission circuit itself generates a second calibration signal which is received by the adjusted measuring circuit, after which the measuring circuit forms a measured value from the received second calibration signal, and the ratio of this measured value to the expected measured value is formed in order to generate a transmission correction factor which adjusts the transmission circuit.

## Revendications

1. Procédé pour le calibrage du circuit d'émission et de mesure d'un dispositif de test,
- dans lequel un générateur de tension d'étalonnage (EI) séparé produit un premier signal d'étalonnage, le générateur de tension d'étalonnage (EI) étant relié à cet effet au circuit de mesure par l'intermédiaire de moyens de commutation,
- et dans lequel, à partir du premier signal d'étalonnage reçu, on forme une valeur de mesure dans le circuit de mesure et on met en rapport cette valeur de mesure et la valeur de mesure attendue afin de produire un facteur de correction de mesure calibrant le circuit de mesure,
caractérisé par le fait que
- les circuits d'émission et de mesure sont interconnectés pour le calibrage consécutif du circuit d'émission,
- le circuit d'émission produit un deuxième signal d'étalonnage qui est reçu par le circuit de mesure maintenant calibré,
- à partir du deuxième signal d'étalonnage reçu, on forme une valeur de mesure dans le circuit de mesure et on met en rapport cette valeur de mesure et la valeur de mesure attendue afin de produire un facteur de correction d'émission calibrant le circuit d'émission.

2. Dispositif de test pour tester un circuit, comportant
a) un circuit d'émission pour émettre des signaux de test vers le dispositif,
b) un circuit de mesure pour recevoir des signaux de réponse dus aux signaux de test et renvoyés par le circuit,
c) un générateur d'étalonnage (EI) qui produit un premier signal d'étalonnage pour le calibrage du circuit de mesure,
d) des premiers moyens de commutation par lesquels le générateur d'étalonnage et le circuit de mesure sont interconnectés pendant le calibrage du circuit de mesure, le circuit de mesure formant une valeur de mesure à partir du premier signal d'étalonnage reçu et mettant en rapport cette valeur de mesure et la valeur de mesure attendue afin de produire un facteur de correction de mesure calibrant le circuit de mesure,
caractérisé par le fait que
e) les circuits d'émission et de mesure sont interconnectés pendant le calibrage du circuit d'émission au moyen de deuxièmes moyens de commutation, et que
f) le circuit d'émission produit pour son calibrage un deuxième signal d'étalonnage, qui est reçu par le circuit de mesure calibré, à la suite de quoi le circuit de mesure produit à partir du deuxième signal d'étalonnage reçu une valeur de mesure et met en rapport cette valeur de mesure et la valeur de mesure attendue afin de produire un facteur de correction d'émission calibrant le circuit d'émission.
